(19) Europäisches Patentamt
European Patent Office
Office européen des brevets

(11) **EP 2 765 435 A1**

(12) **EUROPEAN PATENT APPLICATION**
published in accordance with Art. 153(4) EPC

(43) Date of publication:
**13.08.2014 Bulletin 2014/33**

(51) Int Cl.:
**G01R 31/36** (2006.01)

(21) Application number: **11873694.1**

(22) Date of filing: **06.10.2011**

(86) International application number:
**PCT/JP2011/073114**

(87) International publication number:
**WO 2013/051135 (11.04.2013 Gazette 2013/15)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(71) Applicant: **Hitachi Automotive Systems, Ltd.
Hitachinaka-shi,
Ibaraki 312-8503 (JP)**

(72) Inventors:
• **IGARASHI, Naoyuki
Ibaraki 312-8505 (JP)**

• **OHKAWA Keiichiro
Ibaraki 312-8505 (JP)**
• **KAWAHARA Youhei
Tokyo 100-8280 (JP)**

(74) Representative: **MERH-IP
Matias Erny Reichl Hoffmann
Paul-Heyse-Strasse 29
80336 München (DE)**

(54) **BATTERY CONTROLLER**

(57)     An obj ect of the present invention is to provide a battery controller capable of performing charge and discharge control of a assembly battery so that a state of charge of each battery cell forming a battery does not deviate from a predetermined usage range. The present invention relates to a battery controller which controls a assembly battery 110 formed by connecting a plurality of battery cells 111. The battery controller calculates an actual average charge state $C_{AVE}$ which is an average charge state of the plurality of battery cells 111 on the basis of each state C of charge of the plurality of battery cells 111, calculates an average charge state upper limit value $C_{AVEH}$ and an average charge state lower limit value $C_{AVEL}$ taken by the actual average charge state of the plurality of battery cells 111 in a preset usage range on the basis of each state C of charge and the actual average charge state $C_{AVE}$ of the plurality of battery cells 111, calculates an average charge state ratio S indicating a position of the actual average charge state $C_{AVE}$ between the average charge state upper limit value $C_{AVEH}$ and the average charge state lower limit value $C_{AVEL}$, and calculates a assembly battery charge state $C_{PACK}$ of the assembly battery 110 on the basis of the actual average charge state $C_{AVE}$, the average charge state upper limit value $C_{AVEH}$, the average charge state lower limit value $C_{AVEL}$, and the average charge state ratio S.

[FIG. 3]

EP 2 765 435 A1

**Description**

Technical Field

The present invention relates to a battery controller which controls a state of charge of a assembly battery in which a plurality of battery cells or battery modules are combined with each other.

Background Art

In a storage battery (secondary battery) of which a representative is a lithium ion battery or a nickel hydrogen battery and which can perform charge and discharge, it is considered to be ideal to perform charge and discharge within a range of a chargeable capacity thereof. This is because a so-called over-charge state in which charge is performed over the chargeable capacity and a so-called over-discharge state in which further discharge is performed from a state of no charge may cause deterioration in a storage battery, or dangers such as heat generation or burning may be caused by over-charge or over-discharge. In addition, in order to prevent further deterioration in a battery, designating a region narrower than a region of the chargeable capacity as a usage range and using the battery only within this range is frequently performed.

It is necessary to accurately ascertain a state of charge (SOC) of a storage battery in order to perform charge and discharge within a specific range of a state of charge, and, as methods therefor, various methods have been proposed, such as a method of estimating a state of charge from a voltage of a storage battery, or a method of obtaining a present state of charge from an integrated value of current which has flowed through a storage battery.

In addition, among storage batteries, in a assembly battery formed by a plurality of battery cells, it is necessary not only to accurately obtain a state of charge of each battery cell but also to obtain a state of charge of the assembly battery. This is because, in terms of a host device using a assembly battery, using a single state of charge of the assembly battery, that is, a assembly battery charge state is more suitable for control of the device than using a state of charge of each battery cell. In this case, as a method of most easily obtaining the assembly battery charge state, there may be a method in which an average value which is a value obtained by dividing a total of states of charge of all battery cells by the number of battery cells is used as the assembly battery charge state, a method in which an intermediate value of a maximal state of charge and a minimal state of charge is used as the assembly battery charge state, or the like (PTL 1).

Citation List

Patent Literature

PTL 1: JP-A-11-185823

Summary of Invention

Technical Problem

However, a chargeable capacity of each battery cell forming a assembly battery has a variation due to battery differences at the time immediately after being manufactured, and the chargeable capacity gradually changes due to deterioration over time or deterioration due to repeated charge and discharge of a battery. In addition, even while charge and discharge are performed, each state of charge varies depending on various conditions such as a difference in an internal resistance of an individual battery cell or a variation in a battery temperature.

As mentioned above, when there is a variation in a chargeable capacity or an actual state of charge of each battery cell forming a assembly battery, in a case of using an average value of states of charge of all battery cells or an intermediate value of a maximal state of charge and a minimal state of charge as a assembly battery charge state, a difference necessarily occurs in both of an increase direction and a decrease direction between a state of charge of each battery cell forming a assembly battery and a assembly battery charge state. This is problematic in controlling the assembly battery charge state.

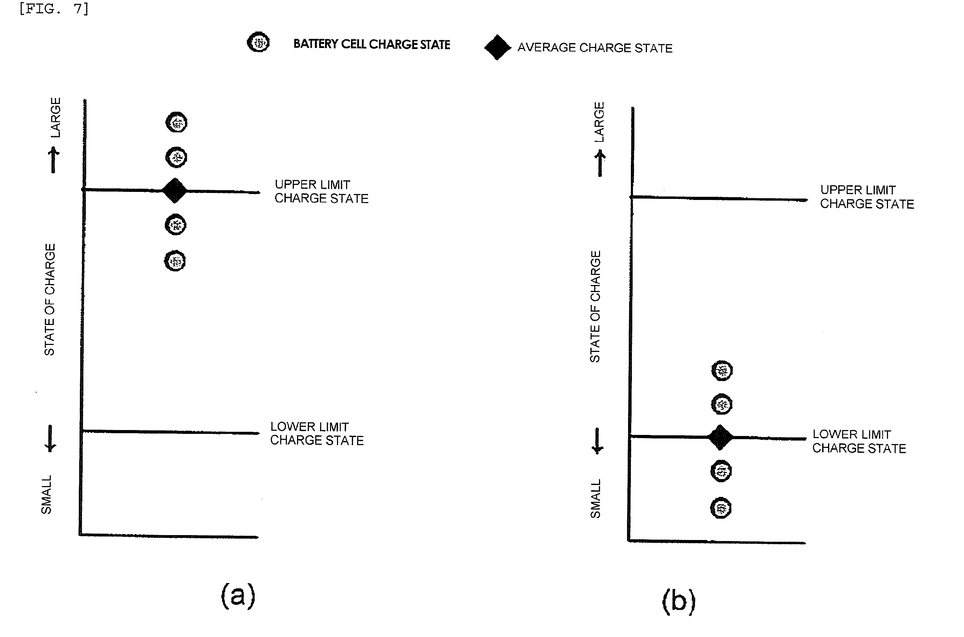

Fig. 7 is graphs illustrating a relationship between a assembly battery charge state and a battery cell charge state (a) in a case where charge is performed up to an upper limit state of charge and (b) in a case where discharge is performed up to a lower limit state of charge, by controlling charge and discharge of a assembly battery with an average state of charge of respective battery cells as the assembly battery charge state, and the state of charge of each battery cell is indicated by a circular mark, and the assembly battery charge state is indicated by a rhombic mark. In a case of (a), it can be seen that battery cells, which have already entered a so-called over-charge state in which charge is performed over a chargeable capacity, are present in the assembly battery. In addition, in a case of (b), if a charge capacity of the assembly battery is discharged to a lower limit state of charge, battery cells, which have already entered a so-called over-discharge state in which discharge is performed over a dischargeable capacity, are present in the assembly battery at that time.

The present invention has been made in consideration of the circumstances, and an obj ect thereof is to provide a battery controller capable of performing charge and discharge control of a assembly battery so that a state of charge of each battery cell forming the assembly battery does not deviate from a predetermined usage range.

Solution to Problem

In order to solve the above-described problems, for example, configurations recited in the claims are employed.

The present description includes a plurality of pieces of means for solving the above-described problems. As an example, a battery controller controls a assembly battery formed by connecting a plurality of battery cells, the battery controller calculating an actual average charge state which is an average charge state of the plurality of battery cells on the basis of each state of charge of the plurality of battery cells; calculating an average charge state upper limit value and an average charge state lower limit value taken by the average charge state of the plurality of battery cells in a preset usage range on the basis of each state of charge and the actual average charge state of the plurality of battery cells; calculating an average charge state ratio indicating a position of the actual average charge state between the average charge state upper limit value and average charge state lower limit value; and calculating a assembly battery charge state of the assembly battery on the basis of the actual average charge state, the average charge state upper limit value, the average charge state lower limit value, and the average charge state ratio.

Advantageous Effects of Invention

According to the present invention, it is possible to perform charge and discharge control of a assembly battery so that a state of charge of each battery cell forming the assembly battery does not deviate from a predetermined usage range. Problems to be solved, configurations, and effects other than the above-described matters will become apparent from description of the following embodiment.

Brief Description of Drawings

[Fig. 1] Fig. 1 is a block diagram illustrating a configuration of a battery system according to an embodiment to which a battery controller of the present invention is applied, and surroundings thereof.

[Fig. 2] Fig. 2 is a block diagram illustrating a circuit configuration of a battery cell control portion.

[Fig. 3] Fig. 3 is a flowchart illustrating calculation procedures of a state of charge related to Example 1.

[Fig. 4] Fig. 4 is a flowchart illustrating calculation procedures of a state of charge related to Example 2.

[Fig. 5] Fig. 5 is a flowchart illustrating calculation procedures of a state of charge related to Example 3.

[Fig. 6] Fig. 6 is a flowchart illustrating calculation procedures of a state of charge related to Example 4.

[Fig. 7] Fig. 7 is a diagram illustrating a relationship between states of charge of battery cells and an average value thereof.

Description of Embodiments

Hereinafter, an embodiment of the present invention will be described in detail.

In the present embodiment, for example, a description will be made of a case where the present invention is applied to a battery system forming a power source of a plug-in hybrid electric vehicle (PHEV). The present embodiment will be described in detail by using a plurality of Examples, and, first, parts common to all of the plurality of Examples will be described, and then each Example will be described individually.

In addition, in the following embodiment, a case of employing a lithium ion battery will be described as an example, but a nickel hydrogen battery, a lead battery, an electric double-layer capacitor, a hybrid capacitor, and the like may be used. Further, in the following embodiment, battery cells are connected in series to each other so as to form a assembly battery, but battery cells which are connected in parallel to each other may be connected in series to each other so as to form a assembly battery, and battery cells which are connected in series to each other may be connected in parallel to each other so as to form a assembly battery.

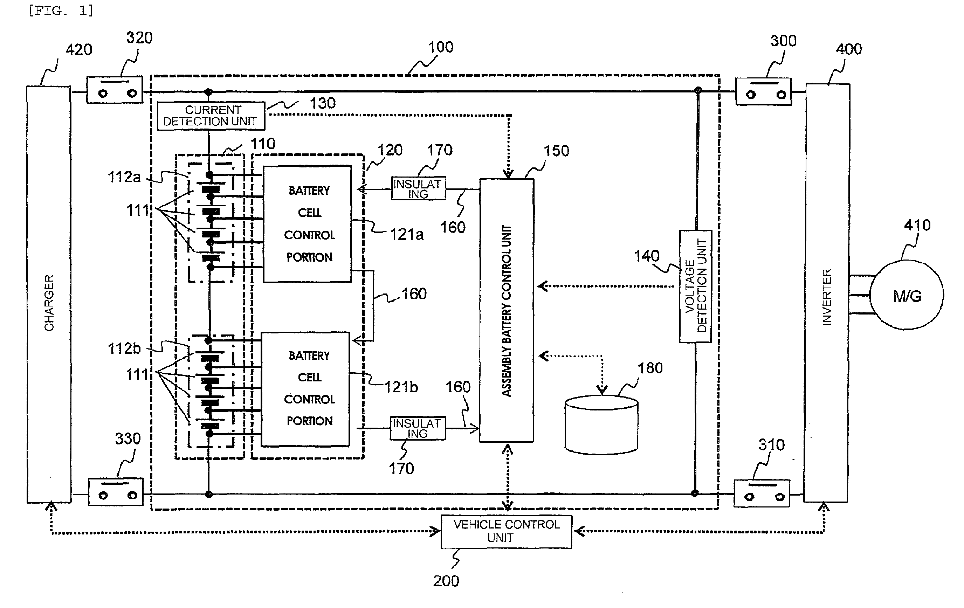

Fig. 1 is a diagram illustrating a circuit configuration of a battery system 100 according to the present embodiment and surroundings thereof. The battery system 100 is connected to an inverter 400 via relays 300 and 310 and is connected to a charger 420 via relays 320 and 330. The battery system 100 includes a assembly battery 110, a battery cell management unit 120, a current detection unit 130, a voltage detection unit 140, a assembly battery control unit 150, and a storage unit 180.

The assembly battery 110 is formed by a plurality of battery cells 111. The battery cell management unit 120 manages states of the battery cells 111 forming the assembly battery 110. The current detection unit 130 detects currents which flow through the battery system 100. The voltage detection unit 140 detects a total voltage of the assembly battery 110. The assembly battery control unit 150 controls the assembly battery 110.

The assembly battery control unit 150 receives information on a battery voltage, a temperature, and the like of the battery cell 111, transmitted by the battery cell management unit 120, information on values of currents which flow through the battery system 100 , transmitted by the current detection unit 130, information on a total voltage value of the assembly battery 110, transmitted by the voltage detection unit 140, and the like. The assembly battery control unit 150 detects a state of the assembly battery 110 on the basis of the received information, so as to control an operation thereof. A process result from the assembly battery control unit 150 is transmitted to the battery cell management unit 120 or a vehicle control unit 200.

The assembly battery 110 is formed by electrically connecting the plurality of battery cells 111 which can accumulate and release electric energy (charge and discharge DC power) in series to each other. The battery cells 111 forming the assembly battery 110 are grouped in a predetermined unit number in performing management and control of states thereof. The grouped battery cells 111 are electrically connected in series to each other, so as to form a plurality of battery cell groups (battery modules) 112a and 112b. The number of battery cells 111 forming each of the battery cell groups 112 may be the same in all the battery cell groups 112, and the number of battery cells 111 may be different for each of the battery cell groups 112.

The battery cell management unit 120 manages states of the battery cells 111 forming the assembly battery 110. The battery cell management unit 120 includes a battery cell control portion 121 provided for each of the battery cell groups 112. In Fig. 1, battery cell control portions 121a and 121b are respectively provided so as to correspond to the battery cell groups 112a and 112b. The battery cell control portions 121 monitor and control states such as battery voltages or temperatures of the battery cells 111 forming the battery cell groups 112.

In the present embodiment, for convenience of description, four battery cells 111 are electrically connected in series to each other so as to form each of the battery cell groups 112a and 112b, and the battery cell groups 112a and 112b are further electrically connected in series to each other so as to form the assembly battery 110 including a total of eight battery cells 111.

The assembly battery control unit 150 and the battery cell management unit 120 perform transmission and reception of signals via insulating elements 170 of which a representative is a photocoupler, and signal communication means 160.

A description will be made of communication means between the assembly battery control unit 150 and the battery cell control portions 121a and 121b forming the battery cell management unit 120. The battery cell control portions 121a and 121b are connected in series in an order of higher potentials of the battery cell groups 112a and 112b which are respectively monitored thereby.

A signal transmitted to the battery cell management unit 120 from the assembly battery control unit 150 is input to the battery cell control portion 121a via the insulating element 170 and the signal communication means 160. An output of the battery cell control portion 121a is input to the battery cell control portion 121b via the signal communication means 160, and an output of the battery cell control portion 121b located at the lowermost position is transmitted to the assembly battery control unit 150 via the insulating element 170 and the signal communication means 160. In the present embodiment, the insulating element 170 is not used between the battery cell control portion 121a and the battery cell control portion 121b, but a signal may be transmitted and received by using the insulating element 170.

The storage unit 180 stores information such as internal resistance characteristics, a capacity at a full charge, polarization characteristics, deterioration characteristics, battery difference information, and a correspondence relationship between an SOC and an open circuit voltage of the assembly battery 110, the battery cells 111, and the battery cell groups 112. In addition, in the present embodiment, the storage unit 180 is configured to be provided outside the assembly battery control unit 150 or the battery cell management unit 120, but the assembly battery control unit 150 or the battery cell management unit 120 may include a storage unit, and the above-described information may be stored therein.

The assembly battery control unit 150 performs a calculation or the like of an SOC, a state of health (SOH), and a current or electric power which can be input and output for one or more battery cells 111, by using information received from the battery cell management unit 120, the current detection unit 130, the voltage detection unit 140, and the vehicle control unit 200, the information stored in the storage unit 180, and the like. In addition, various calculation results are transmitted to the battery cell management unit 120 or the vehicle control unit 200.

The vehicle control unit 200 controls the inverter 400 which is connected to the battery system 100 via the relays 300 and 310, by using the information received from the assembly battery control unit 150. In addition, the charger 420 is controlled which is connected to the battery system 100 via the relays 320 and 330. During traveling of a vehicle, the battery system 100 is connected to the inverter 400, and drives a motor generator 410 by using the energy stored in the assembly battery 110. During charging, the battery system 100 is connected to the charger 420, and is charged by electric power supply from a domestic power source or a charging stand.

The charger 420 is used to charge the assembly battery 110, by using an external power source of which a representative is the domestic power source or the charging stand. In the present embodiment, the charger 420 controls a charge voltage, a charge current, or the like on the basis of a command from the assembly battery control unit 150 or the vehicle control unit 200.

In a case where a vehicle system having the battery system 100 mounted therein is started so as to allow traveling, under the management of the vehicle control unit 200, the battery system 100 is connected to the inverter 400, and drives the motor generator (M/G) 410 by using the energy stored in the assembly battery 110, and charges the assembly battery 110 by using electric power generated by the motor generator 410 during regeneration.

When a vehicle including the battery system 100 is connected to the external power source of which a representative is the domestic power source or the electric stand, the battery system 100 is connected to the charger 420 on the basis of information transmitted by the vehicle control unit 200, and the assembly battery 110 is charged until reaching a predetermined condition. The energy stored in the assembly battery 110 by the charging is used in the vehicle next travels, and is also used to operate electric components inside and outside the vehicle.

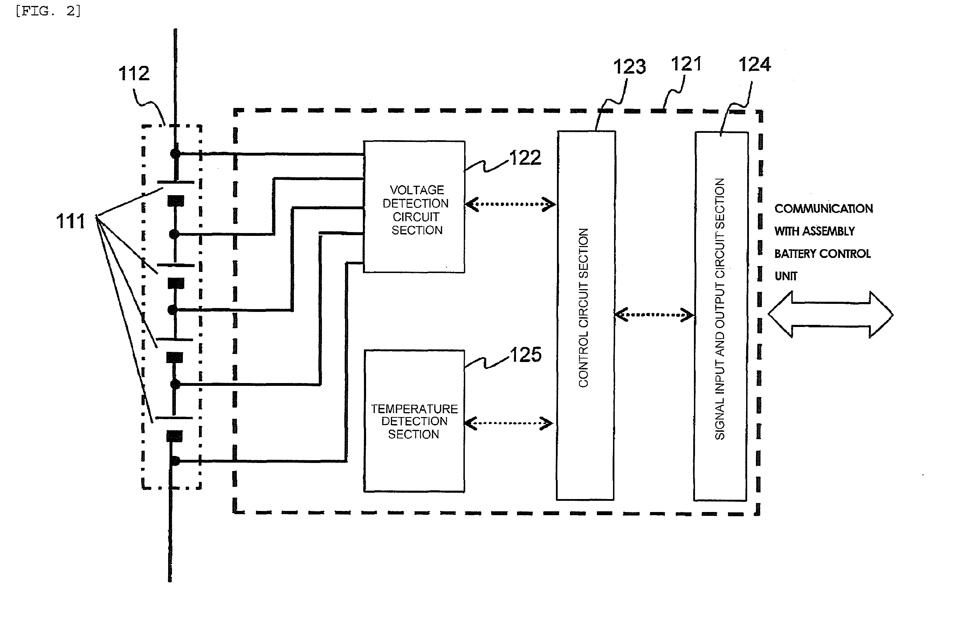

Fig. 2 is a diagram illustrating a circuit configuration of the battery cell control portion 121. The battery cell control portion 121 includes a voltage detection circuit section 122, a control circuit section 123, a signal input and output circuit section 124, and a temperature detection section 125. The voltage detection circuit section 122 measures a voltage between terminals of each battery cell 111. The temperature detection section 125 measures a temperature of the battery cell group 112. The control circuit section 123 receives measurement results from the voltage detection circuit section 122 and the temperature detection section 125, and transmits the results to the assembly battery control unit 150 via the signal input and output circuit section 124. In addition, a circuit configuration, which is generally mounted in the battery cell control portion 121 and uniformizes voltage or SOC variations between the battery cells 111 occurring due to self discharge, current consumption variations, or the like, has been judged to be well known, and thus a description thereof has been omitted.

The temperature detection section 125 included in the battery cell control portion 121 of Fig. 2 has a function of measuring a temperature of the battery cell group 112. The temperature detection section 125 measures a single temperature in the battery cell group 112. The temperature measured by the temperature detection section 125 is treated as a representative temperature value of the battery cells 111 forming the battery cell group 112, and is used for various calculations for detecting a state of the battery cell 111 or the battery cell group 112, or the assembly battery 110.

Fig. 2 is based on the above-described fact, and thus a single temperature detection section 125 is provided in the battery cell control portion 121. The temperature detection section 125 may be provided for each battery cell 111 so as to measure a temperature of each battery cell 111, and various calculations may be performed on the basis of the temperature of each battery cell 111.

Fig. 2 illustrates the temperature detection section 125 in a simplified manner, but, in practice, a temperature sensor is installed in a temperature measurement target, and the installed temperature sensor outputs temperature information as a voltage. In addition, the measurement result is transmitted to the signal input and output circuit 124 via the control circuit 123, and the signal input and output circuit 124 outputs the measurement result to outside of the battery cell control portion 121. A function of realizing the series of flows is mounted in the battery cell control portion 121 as the temperature detection section 125. The voltage detection circuit 122 may be used to measure temperature information (voltage).

As mentioned above, the configuration of the battery system 100 has been described. Next, Examples based on the battery system will be described in detail.

In the following respective Examples, a calculation method of a assembly battery charge state and a use form are described. The present invention relates to a calculation method of a assembly battery charge state, and a state of charge of each battery cell is used to calculate the assembly battery charge state. Various methods of estimating a state of charge of each battery cell have been proposed and are well known in the related art, and, for example, a method or the like is generally well known in which a relationship between an open circuit voltage (OCV), a battery temperature, and a state of charge of a battery cell is measured in advance, and a state of charge is estimated from the open circuit voltage and the battery temperature on the basis of the data. In a calculation of a assembly battery charge state according to the present invention, a calculation method of a state of charge of a battery cell is not limited, and any method may be used. Therefore, description of calculation and estimation methods of a state of charge of a battery cell will be omitted in the present embodiment.

[Example 1]

In the present example, in all the battery cells 111 forming the assembly battery 110, in a case where a maximal charge state $C_{MAX}$ which is a maximal state of charge is equal to or more than an upper limit charge state $C_{USGMAX}$ which is set in advance, a process is performed in which a assembly battery charge state $C_{PACK}$ is calculated as the same value as the maximal charge state $C_{MAX}$, and, in a case where a minimal charge state $C_{MIN}$ which is a minimal state of charge is equal to or less than a lower limit charge state $C_{USGMIN}$ which is set in advance, a process is performed in which the assembly battery charge state $C_{PACK}$ is calculated as the same value as the minimal charge state $C_{MIN}$.

In addition, in a case where a state C of charge of each battery cell is in a normal usage range which is more than the lower limit charge state $C_{USGMIN}$ and less than the upper limit charge state $C_{USGMAX}$, a process is performed in which an average charge state (actual average charge state) $C_{AVE}$ of the battery cells 111, an average charge state upper limit value which is an upper limit value of the average charge state $C_{AVE}$, and an average charge state lower limit value which is a lower limit value of the average charge state $C_{AVE}$ are calculated, and the assembly battery charge state $C_{PACK}$ is calculated on the basis of a position of the average charge state $C_{AVE}$ between an average charge state upper limit value $C_{AVEH}$ and an average charge state lower limit value $C_{AVEL}$.

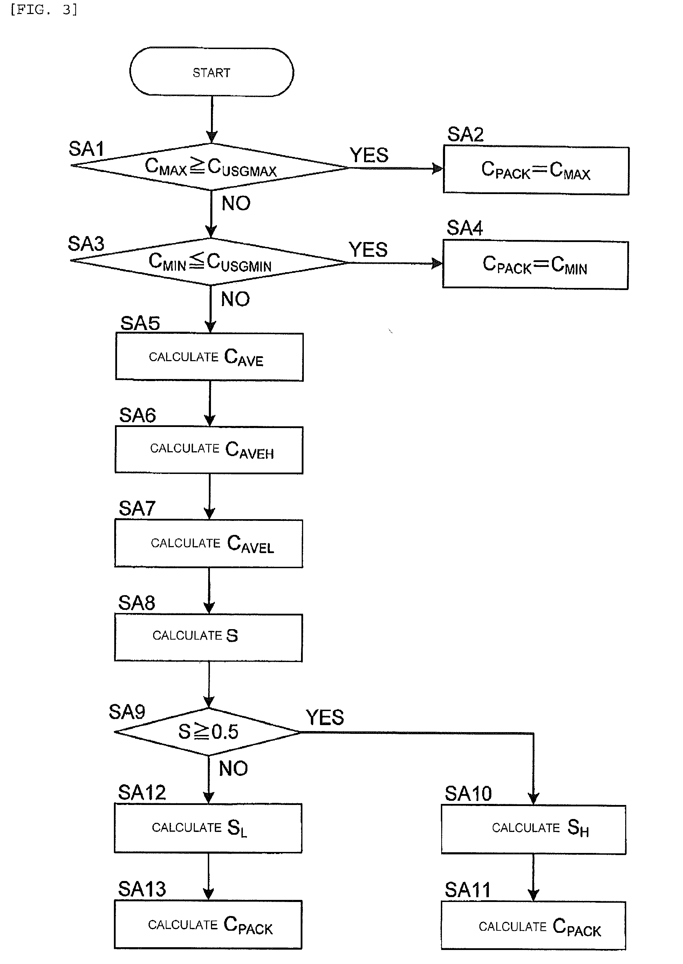

Fig. 3 illustrates a calculation flow for a assembly battery charge state performed in the present example.

The assembly battery control unit 150 or the storage unit 180 records an SOC of 90% in advance as the upper limit charge state $C_{USGMAX}$ which is an upper limit state of charge in a normal usage range of a battery, and similarly records an SOC of 20% as the lower limit charge state $C_{USGMIN}$ which is a lower limit state of charge in the normal usage range. Such numerical values of SOC are not limited to the above numerical values, and may employ optimal values based on characteristics, a usage method and a usage environment of a battery.

The assembly battery control unit 150 sequentially calculates a state of charge of each battery cell 111 on the basis of various information obtained through the battery cell management unit 120. After states of charge of all the battery cells 111 are calculated, the assembly battery control unit 150 calculates the assembly battery charge state $C_{PACK}$ from the states of charge of the respective battery cells 111 in the following method.

First, a maximal value of the states C of charge of all the battery cells 111 is set as the maximal charge state $C_{MAX}$, and a minimal value of the states C of charge of all the battery cells 111 is set as the minimal charge state $C_{MIN}$. In addition, in step SA1, the maximal charge state $C_{MAX}$ is compared with the upper limit charge state $C_{USGMAX}$, and if the maximal charge state $C_{MAX}$ is a value which is equal to or greater than the upper limit charge state $C_{USGMAX}$ (YES), the battery cell 111 of which a state of charge has already deviated from the normal usage range is present. In step SA2, the assembly battery charge state $C_{PACK}$ is set to the same value as the maximal charge state $C_{MAX}$, and the calculation of the assembly battery charge state $C_{PACK}$ finishes.

On the other hand, in step SA1, if the maximal charge state $C_{MAX}$ is not a value which is equal to or greater than the upper limit charge state $C_{USGMAX}$, that is, the maximal charge state $C_{MAX}$ is smaller than the upper limit charge state $C_{USGMAX}$ (NO), the flow proceeds to step SA3.

In step SA3, the minimal charge state $C_{MIN}$ is compared with the lower limit charge state $C_{USGMIN}$, and if the minimal charge state $C_{MIN}$ is a value which is equal to or smaller than the lower limit charge state $C_{USGMIN}$ (YES), the battery cell 111 of which a state of charge has already deviated from the normal usage range is present. In step SA4, the assembly battery charge state $C_{PACK}$ is set to the same value as the minimal charge state $C_{MIN}$, and the calculation of the assembly battery charge state $C_{PACK}$ finishes.

At the time of reaching step SA5, the states C of charge of all the battery cells 111 are located between the upper limit charge state $C_{USGMAX}$ and the lower limit charge state $C_{USGMIN}$.

In step SA5, the average charge state (actual average charge state) $C_{AVE}$ of the battery cells 111 is calculated on the basis of the states C of charge of all the battery cells 111 (actual average charge state calculation means). The average charge state $C_{AVE}$ is obtained by dividing a sum of the states C of charge of all the battery cells 111 by the number of battery cells 111.

Next, in step SA6, the average charge state upper limit value $C_{AVEH}$ is obtained by using the following Equation (1) (average charge state upper limit value calculation means).

$$C_{AVEH} = C_{USGMAX} - (C_{MAX} - C_{AVE}) \quad (1)$$

The average charge state upper limit value $C_{AVEH}$ of the above Equation (1) is an upper limit value of the average charge state $C_{AVE}$, and is an average charge state $C_{AVE}$ in a case where the maximal charge state $C_{MAX}$ of the states C of charge is assumed to be the same value as the upper limit charge state $C_{USGMAX}$ while maintaining a gap (difference) between the respective states C of charge in the states C of charge of the respective battery cells 111 during measurement.

Next, in step SA7, the average charge state lower limit value $C_{AVEL}$ is obtained by using the following Equation (2) (average charge state lower limit value calculation means).

$$C_{AVEL} = C_{USGMIN} + (C_{AVE} - C_{MIN}) \quad (2)$$

The average charge state lower limit value $C_{AVEL}$ is a lower limit value of the average charge state $C_{AVE}$, and is an average charge state $C_{AVE}$ in a case where the minimal charge state $C_{MIN}$ of the states C of charge is assumed to be the same value as the lower limit charge state $C_{USGMIN}$ while maintaining a gap (difference) between states C of charge in relation to the states C of charge of the respective battery cells 111 during measurement.

At this time, in a case where the states C of charge of all the battery cells 111 are located between the upper limit charge state $C_{USGMAX}$ and the lower limit charge state $C_{USGMIN}$, the average charge state $C_{AVE}$ is located only between the average charge state upper limit value $C_{AVEH}$ and the average charge state lower limit value $C_{AVEL}$.

Next, in step SA8, an average charge state ratio S is obtained by using the following Equation (3) (average charge state ratio calculation means).

$$S = (C_{AVE} - C_{AVEL}) / (C_{AVEH} - C_{AVEL}) \quad (3)$$

The average charge state ratio S is a ratio value indicating where the average charge state $C_{AVE}$ is located between the average charge state upper limit value $C_{AVEH}$ and the average charge state lower limit value $C_{AVEL}$, and is expressed by a value in a range between 0 and 1 when 1 is set in a case where the average charge state $C_{AVE}$ is the same as the average charge state upper limit value $C_{AVEH}$ and 0 is set in a case where the average charge state $C_{AVE}$ is the same as the average charge state lower limit value $C_{AVEL}$.

Here, in a case where the average charge state $C_{AVE}$ is located at a half-way position (intermediate position) between the average charge state upper limit value $C_{AVEH}$ and the average charge state lower limit value $C_{AVEL}$, that is, the average charge state ratio S is S=0.5, an average charge state is set as an average charge state intermediate value $C_{AVEM}$ (average charge state intermediate value calculation means). In the calculation of the assembly battery charge state $C_{PACK}$ of the present example, if the average charge state ratio S is obtained, then, the average charge state ratio S is sorted and calculated with 0.5 as a boundary in order to determine whether the assembly battery charge state $C_{PACK}$ becomes close to the maximal charge state $C_{MAX}$ or the minimal charge state $C_{MIN}$.

In step SA9, if the average charge state ratio S is S≥0.5 (YES), the maximal charge state $C_{MAX}$ and the average charge state CAVE are used to calculate the assembly battery charge state $C_{PACK}$.

First, in step SA10, an average charge state upper ratio $S_H$ is obtained by using the following Equation (4) (average charge state upper ratio calculation means).

$$S_H = (S - 0.5) \times 2 \quad (4)$$

The average charge state upper ratio $S_H$ is a ratio value indicating where the average charge state $C_{AVE}$ is located between the average charge state intermediate value $C_{AVEM}$ and the average charge state upper limit value $C_{AVEH}$, and is expressed by a value in a range between 0 and 1 when 0 is set in a case where the average charge state $C_{AVE}$ is the same as the average charge state intermediate value $C_{AVEM}$ and 1 is set in a case where the average charge state $C_{AVE}$ is the same as the average charge state upper limit value $C_{AVEH}$.

In addition, in step SA11, the assembly battery charge state $C_{PACK}$ is obtained by using the following Equation (5) (assembly battery charge state calculation means), and the calculation of the assembly battery charge state $C_{PACK}$ finishes.

$$C_{PACK} = S_H \times C_{MAX} + (1 - S_H) \times C_{AVE} \quad (5)$$

In contrast, in step SA9, if the average charge state ratio S is S<0.5 (NO), the minimal charge state $C_{MIN}$ and the average charge state $C_{AVE}$ are used to calculate the assembly battery charge state $C_{PACK}$.

First, in step SA12, an average charge state lower ratio $S_L$ is obtained by using the following Equation (6) (average charge state lower ratio calculation means).

$$S_L = S \times 2 \quad (6)$$

The average charge state lower ratio $S_L$ is a ratio value indicating where the average charge state $C_{AVE}$ is located between the average charge state lower limit value $C_{AVEL}$ and the average charge state intermediate value $C_{AVEM}$, and is expressed by a value in a range between 0 and 1 when 0 is set in a case where the average charge state $C_{AVE}$ is the same as the average charge state lower limit value $C_{AVEL}$ and 1 is set in a case where the average charge state $C_{AVE}$ is the same as the average charge state intermediate value $C_{AVEM}$.

In addition, in step SA13, the assembly battery charge state $C_{PACK}$ is obtained by using the following Equation (7) (assembly battery charge state calculation means), and the calculation of the assembly battery charge state $C_{PACK}$ finishes..

$$C_{PACK} = S_L \times C_{AVE} + (1-S_L) \times C_{MIN} \quad (7)$$

Due to the above-described calculation, the assembly battery charge state $C_{PACK}$ takes values which are set between the upper limit charge state $C_{USGMAX}$ and the lower limit charge state $C_{USGMIN}$ and continuously varies in accordance with the average charge state ratio S.

The assembly battery control unit 150 sends the assembly battery charge state $C_{PACK}$ which is the calculation result to the vehicle control unit 200. On the basis of the assembly battery charge state $C_{PACK}$, the vehicle control unit 200 extracts electric power from the assembly battery 110 so as to drive the motor generator 410 by controlling the inverter 400, allows electric power generated by the motor generator 410 to be regenerated in the assembly battery 110, or controls the charger 420 so as to charge the assembly battery 110.

As long as the assembly battery charge state $C_{PACK}$ which has been obtained due to the above-described procedures continuously varies between the lower limit charge state $C_{USGMIN}$ and the upper limit charge state $C_{USGMAX}$, and is located between the lower limit charge state $C_{USGMIN}$ and the upper limit charge state $C_{USGMAX}$, the states C of charge of all the battery cells 111 forming the assembly battery 110 are in the normal usage range from the lower limit charge state $C_{USGMIN}$ to the upper limit charge state $C_{USGMAX}$, and thus can be controlled so as not to deviate from the normal usage range.

According to the present example, the assembly battery charge state $C_{PACK}$ can be calculated each time the state C of charge of each battery cell 111 is detected. Therefore, unlike in the technique disclosed in PTL 1 of the related art, it is not necessary to obtain an SOC movable range by varying an SOC to a maximal state and a minimal state, and the assembly battery charge state can be calculated at any time including the time immediately after starting of use.

In addition, according to the present example, the assembly battery charge state $C_{PACK}$ can become close to the upper limit charge state $C_{USGMAX}$ or the lower limit charge state $C_{USGMIN}$ depending on whether the assembly battery charge state transfers to a higher range or a lower range. Therefore, an SOC change amount relative to power consumption is substantially constant in the overall range from the lower limit charge state $C_{USGMIN}$ to the upper limit charge state $C_{USGMAX}$, and, for example, it becomes easier to predict residual electric power when the plug-in hybrid electric vehicle (PHEV) is traveling with constant power consumption.

In addition, in the above-described example, a case of using an average value (average charge state $C_{AVE}$ or the like) of the battery cells 111 has been described as an example, but an intermediate value may be used instead of the average value. However, the average value can more accurately indicate a state of charge in a total state of charge of the assembly battery 110.

[Example 2]

Next, Example 2 will be described.

One of features of the present example is that the normal usage range between the lower limit charge state $C_{USGMIN}$ and the upper limit charge state $C_{USGMAX}$ is divided into three ranges including a high SOC range, a low SOC range, and a central SOC range, and, if the maximal charge state $C_{MAX}$ and the minimal charge state $C_{MIN}$ are in the central SOC range, the average charge state $C_{AVE}$ is calculated as the assembly battery charge state $C_{PACK}$, and if the maximal charge state $C_{MAX}$ is in the high SOC range, or the minimal charge state $C_{MIN}$ is in the low SOC range, in the same manner as in Example 1, a process is performed in which the assembly battery charge state $C_{PACK}$ is calculated on the basis of a position of the average charge state $C_{AVE}$ between the average charge state upper limit value $C_{AVEH}$ and the average charge state lower limit value $C_{AVEL}$.

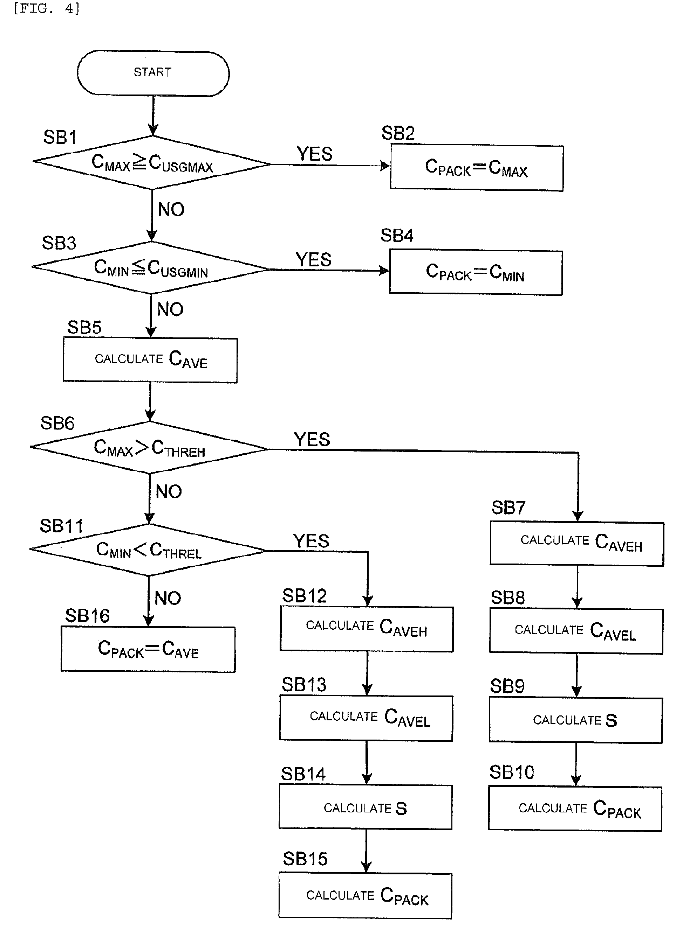

Fig. 4 illustrates a calculation flow for a assembly battery charge state performed in the present example.

The assembly battery control unit 150 or the storage unit 180 records an SOC of 90% in advance as the upper limit charge state $C_{USGMAX}$ which is an upper limit state of charge in a normal usage range of a battery, and similarly records an SOC of 20% as the lower limit charge state $C_{USGMIN}$ which is a lower limit state of charge in the normal usage range. In addition, an SOC of 80% is recorded as an upper boundary charge state $C_{THREH}$, and an SOC of 30% is recorded as a lower boundary charge state $C_{THREL}$, used when the assembly battery charge state $C_{PACK}$ is obtained. Such numerical values of SOC are not limited to the above numerical values, and may employ optimal values based on characteristics, a usage method and a usage environment of a battery.

The upper boundary charge state $C_{THREH}$ and the lower boundary charge state $C_{THREL}$ are boundary charge states which allow a calculation method of a state of charge to be changed by using the values as boundaries, and are set as values for dividing the normal usage range into three ranges including the high SOC range, the low SOC range, and the central SOC range. In the normal usage range, a range between the upper limit charge state $C_{USGMAX}$ and the upper boundary charge state $C_{THREH}$ is set as the high SOC range, a range between the lower limit charge state $C_{USGMIN}$ and the lower boundary charge state $C_{THREL}$ is set as the low SOC range, and a range between the upper boundary charge state $C_{THREH}$ and the lower boundary charge state $C_{THREL}$ is set as the central SOC range.

The assembly battery control unit 150 sequentially calculates the state C of charge of each battery cell 111 on the basis of various information obtained through the battery cell management unit 120. After states of charge of all the battery cells 111 are calculated, the assembly battery control unit 150 calculates the assembly battery charge state $C_{PACK}$ from the states C of charge of the respective battery cells 111 in the following method.

First, a maximal value of the states C of charge of all the battery cells 111 is set as the maximal charge state $C_{MAX}$, and a minimal value of the states C of charge of all the battery cells 111 is set as the minimal charge state $C_{MIN}$. In addition, in step SB1, the maximal charge state $C_{MAX}$ is compared with the upper limit charge state $C_{USGMAX}$, and if the maximal charge state $C_{MAX}$ is a value which is equal to or greater than the upper limit charge state $C_{USGMAX}$ (YES), the battery cell 111 of which a state C of charge has already deviated from the normal usage range is present. In step SB2, the assembly battery charge state $C_{PACK}$ is set to the same value as the maximal charge state $C_{MAX}$, and the calculation of the assembly battery charge state $C_{PACK}$ finishes.

On the other hand, in step SB1, if the maximal charge state $C_{MAX}$ is not a value which is equal to or greater than the upper limit charge state $C_{USGMAX}$, that is, the maximal charge state $C_{MAX}$ is less than the upper limit charge state $C_{USGMAX}$ (NO), the flow proceeds to step SB3.

In step SB3, the minimal charge state $C_{MIN}$ is compared with the lower limit charge state $C_{USGMIN}$, and if the minimal charge state $C_{MIN}$ is a value which is equal to or smaller than the lower limit charge state $C_{USGMIN}$ (YES), the battery cell 111 of which a state of charge has already deviated from the normal usage range is present. In step SB4, the assembly battery charge state $C_{PACK}$ is set to the same value as the minimal charge state $C_{MIN}$, and the calculation of the assembly battery charge state $C_{PACK}$ finishes.

At the time of reaching step SB5, the states C of charge of all the battery cells 111 are located between the upper limit charge state $C_{USGMAX}$ and the lower limit charge state $C_{USGMIN}$.

In step SB5, the average charge state $C_{AVE}$ is calculated (actual average charge state calculation means). The average charge state $C_{AVE}$ is obtained by dividing a sum of the states C of charge of all the battery cells 111 by the number of battery cells 111.

In step SB6, the maximal charge state $C_{MAX}$ is compared with the upper boundary charge state $C_{THREH}$, and it is determined whether or not the maximal charge state $C_{MAX}$ is in the high SOC range. Here, if the maximal charge state $C_{MAX}$ exceeds the upper boundary charge state $C_{THREH}$ (YES), it is determined that the maximal charge state $C_{MAX}$ is in the high SOC range, and a process is performed in which the average charge state upper limit value $C_{AVEH}$ is obtained by using the following Equation (8) in step SB7 (average charge state upper limit value calculation means) .

$$C_{AVEH} = C_{USGMAX} - (C_{MAX} - C_{AVE}) \quad (8)$$

The average charge state upper limit value $C_{AVEH}$ of the above Equation (8) is an upper limit value of the average charge state $C_{AVE}$ when the maximal charge state $C_{MAX}$ is in the high SOC range, and is an average charge state $C_{AVE}$ in a case where the maximal charge state $C_{MAX}$ of the states C of charge is assumed to be the same value as the upper limit charge state $C_{USGMAX}$ while maintaining a gap (difference) between states C of charge in relation to the states C of charge of the respective battery cells 111 during measurement.

Next, in step SB8, the average charge state lower limit value $C_{AVEL}$ is obtained by using the following Equation (9) (average charge state lower limit value calculation means).

$$C_{AVEL} = C_{THREH} - (C_{MAX} - C_{AVE}) \quad (9)$$

The average charge state lower limit value $C_{AVEL}$ of Equation (9) is a lower limit value of the average charge state $C_{AVE}$ when the maximal charge state $C_{MAX}$ is in the high SOC range, and is an average charge state $C_{AVE}$ in a case where the maximal charge state $C_{MAX}$ of the states C of charge is assumed to be the same value as the upper boundary charge state $C_{THREH}$ while maintaining a gap (difference) between states C of charge in relation to the states C of charge of the respective battery cells 111 during measurement.

In a case where the maximal charge state $C_{MAX}$ is located between the upper limit charge state $C_{USGMAX}$ and the upper boundary charge state $C_{THREH}$ (in a case where the maximal charge state is in the high SOC range), the average charge state $C_{AVE}$ is located only between the average charge state upper limit value $C_{AVEH}$ and the average charge state lower limit value $C_{AVEL}$.

Next, in step SB9, the average charge state ratio S is obtained by using the following Equation (10) (average charge state ratio calculation means).

$$S = (C_{AVE} - C_{AVEL}) / (C_{AVEH} - C_{AVEL}) \quad (10)$$

The average charge state ratio S is a ratio value indicating where the average charge state $C_{AVE}$ is located between the average charge state upper limit value $C_{AVEH}$ and the average charge state lower limit value $C_{AVEL}$, and is expressed by a value in a range between 0 and 1 when 1 is set in a case where the average charge state $C_{AVE}$ is the same as the average charge state upper limit value $C_{AVEH}$ and 0 is set in a case where the average charge state $C_{AVE}$ is the same as the average charge state lower limit value $C_{AVEL}$.

In addition, in step SB10, the assembly battery charge state $C_{PACK}$ is obtained by using the following Equation (11) (assembly battery charge state calculation means), and the calculation of the assembly battery charge state $C_{PACK}$ finishes.

$$C_{PACK} = S \times C_{MAX} + (1-S) \times C_{AVE} \quad (11)$$

In contrast, in step SB6, if the maximal charge state $C_{MAX}$ does not exceed the upper boundary charge state $C_{THREH}$ (NO), the flow proceeds to step SB11.

In step SB11, it is determined whether or not the minimal charge state $C_{MIN}$ is in the low SOC range. Here, the minimal charge state $C_{MIN}$ is compared with the lower boundary charge state $C_{THREL}$, and if the minimal charge state $C_{MIN}$ is less than the lower boundary charge state $C_{THREL}$ (YES), it is determined that the minimal charge state $C_{MIN}$ is in the low SOC range. In step SB12, the average charge state upper limit value $C_{AVEH}$ is obtained by using the following Equation (12) (average charge state upper limit value calculation means).

$$C_{AVEH} = C_{THREL} + (C_{AVE} - C_{MIN}) \quad (12)$$

The average charge state upper limit value $C_{AVEH}$ of the above Equation (12) is an upper limit value of the average charge state $C_{AVE}$ when the minimal charge state $C_{MIN}$ is in the low SOC range, and is an average charge state $C_{AVE}$ in a case where the minimal charge state $C_{MIN}$ of the states C of charge is assumed to be the same value as the lower boundary charge state $C_{THREL}$ while maintaining a gap (difference) between states C of charge in relation to the states C of charge of the respective battery cells 111 during measurement.

Next, in step SB13, the average charge state lower limit value $C_{AVEL}$ is obtained by using the following Equation (13) (average charge state lower limit value calculation means).

$$C_{AVEL} = C_{USGMIN} + (C_{AVE} - C_{MIN}) \quad (13)$$

The average charge state lower limit value $C_{AVEL}$ of the above Equation (13) is a lower limit value of the average charge state $C_{AVE}$ when the minimal charge state $C_{MIN}$ is in the low SOC range, and is an average charge state $C_{AVE}$ in a case where the minimal charge state $C_{MIN}$ of the states C of charge is assumed to be the same value as the lower limit charge state $C_{USGMIN}$ while maintaining a gap (difference) between states C of charge in relation to the states C of charge of the respective battery cells 111 during measurement.

At this time, in a case where the minimal charge state $C_{MIN}$ is located between the lower boundary charge state $C_{THREL}$ and the lower limit charge state $C_{USGMIN}$ (in a case where it is in the low SOC range), the average charge state $C_{AVE}$ is located only between the average charge state upper limit value $C_{AVEH}$ and the average charge state lower limit value $C_{AVEL}$.

Next, in step SB14, the average charge state ratio S is obtained by using the following Equation (14) (average charge state ratio calculation means).

$$S = (C_{AVE} - C_{AVEL}) / (C_{AVEH} - C_{AVEL}) \quad (14)$$

The average charge state ratio S is a ratio value indicating where the average charge state $C_{AVE}$ is located between the average charge state upper limit value $C_{AVEH}$ and the average charge state lower limit value $C_{AVEL}$, and is expressed by a value in a range between 0 and 1 when 1 is set in a case where the average charge state $C_{AVE}$ is the same as the average charge state upper limit value $C_{AVEH}$ and 0 is set in a case where the average charge state $C_{AVE}$ is the same as the average charge state lower limit value $C_{AVEL}$.

In addition, in step SB15, the assembly battery charge state $C_{PACK}$ is obtained by using the following Equation (11), and the calculation of the assembly battery charge state $C_{PACK}$ finishes.

$$C_{PACK} = S \times C_{AVE} + (1-S) \times C_{MIN} \quad (11)$$

In addition, if the maximal charge state $C_{MAX}$ is less than the upper boundary charge state $C_{THREH}$ (NO in SB6), and the minimal charge state $C_{MIN}$ is more than the lower boundary charge state $C_{THREL}$ (NO in SB11), it is determined that the maximal charge state $C_{MAX}$ and the minimal charge state $C_{MIN}$ are in the central SOC range, and the flow proceeds to step SB16. In step SB16, a process is performed in which the assembly battery charge state $C_{PACK}$ is set to the same value as the average charge state $C_{AVE}$ (assembly battery charge state calculation means), and the calculation of the assembly battery charge state $C_{PACK}$ finishes.

Due to the above-described calculation, the assembly battery charge state $C_{PACK}$ is calculated as the same value as the average charge state $C_{AVE}$ in a case where the maximal charge state $C_{MAX}$ and the minimal charge state $C_{MIN}$ are in the central SOC range. In addition, in a case where the maximal charge state $C_{MAX}$ is in the high SOC range, or the minimal charge state $C_{MIN}$ is in the low SOC range, the assembly battery charge state $C_{PACK}$ takes values which are set on the basis of a position of the average charge state $C_{AVE}$ between the average charge state upper limit value $C_{AVEH}$ and the average charge state lower limit value $C_{AVEL}$ and continuously vary in accordance with the average charge state ratio S.

The assembly battery control unit 150 sends the assembly battery charge state $C_{PACK}$ which is the calculation result to the vehicle control unit 200. On the basis of the assembly battery charge state $C_{PACK}$, the vehicle control unit 200 extracts electric power from the assembly battery 110 so as to drive the motor generator 410 by controlling the inverter 400, allows electric power generated by the motor generator 410 to be regenerated in the assembly battery 110, or controls the charger 420 so as to charge the assembly battery 110.

The assembly battery charge state $C_{PACK}$ obtained due to the above-described procedures is calculated as the same value as the average charge state $C_{AVE}$ in a case where the maximal charge state $C_{MAX}$ and the minimal charge state $C_{MIN}$ are in the central SOC range between the lower boundary charge state $C_{THREL}$ and the upper boundary charge state $C_{THREH}$. In addition, the assembly battery charge state is calculated on the basis of the average charge state ratio S indicating a position of the average charge state $C_{AVE}$ between the average charge state upper limit value $C_{AVEH}$ and the average charge state lower limit value $C_{AVEL}$ in a case where the minimal charge state $C_{MIN}$ is in the low SOC range between the lower limit charge state $C_{USGMIN}$ and the lower boundary charge state $C_{THREL}$, or the maximal charge state $C_{MAX}$ is in the high SOC range between the upper boundary charge state $C_{THREH}$ and the upper limit charge state $C_{USGMAX}$. Therefore, as long as the assembly battery charge state $C_{PACK}$ is located between the lower limit charge state $C_{USGMIN}$ and the upper limit charge state $C_{USGMAX}$, the states C of charge of all the battery cells 111 forming the assembly battery 110 are in the normal usage range from the lower limit charge state $C_{USGMIN}$ to the upper limit charge state $C_{USGMAX}$, and thus can be controlled so as not to deviate from the normal usage range.

According to the present example, since the average charge state CAVE is calculated as the assembly battery charge state $C_{PACK}$ in a case where the maximal charge state $C_{MAX}$ and the minimal charge state $C_{MIN}$ are in the central SOC range, it is possible to prevent an estimation in which the assembly battery charge state $C_{PACK}$ is calculated as a value less than the average charge state $C_{AVE}$ and thus an output characteristic of a battery is low on the low SOC range side within the central SOC range. Therefore, it is possible to sufficiently use the performance of the battery.

[Example 3]

Next, Example 3 will be described.

One of features of the present example is that a process is performed in which the assembly battery charge state $C_{PACK}$ is calculated by using the average charge state ratio S only in the high SOC range of Example 2, and the average charge state $C_{AVE}$ is calculated as the assembly battery charge state $C_{PACK}$ in the central SOC range and the low SOC range.

Although the assembly battery charge state $C_{PACK}$ is calculated by performing the calculation using the average charge state ratio S in the overall normal usage range in the above Example 1 and by performing the calculation using the average charge state ratio S in both of the high SOC range and the low SOC range in the above Example 2, the calculation method may be used in either of a high state of charge (high SOC range) and a low state of charge (low SOC range).

For example, a hybrid electric vehicle has a narrower normal usage range of a state of charge than a plug-in hybrid electric vehicle, a pure electric vehicle, or the like, and thus strict control of a state of charge is not required in charge and discharge of a battery. Therefore, there is no problem even if an average charge state of respective battery cells is used as a assembly battery charge state, but there is a case where strict control on a high charge state side which may cause over-charge which is severe circumstances in a battery is desired to be performed.

In addition, in a case where only a single state C of charge of the battery cells 111 forming the assembly battery 110 protrudes toward a low charge state side, if Example 1 and Example 2 are applied thereto, the performance of a battery may not be sufficiently used since the assembly battery charge state $C_{PACK}$ follows the state C of charge of this battery cell 111 and is thus calculated to be considerably lower than an average value (average charge state $C_{AVE}$), and as a result, an output characteristic of the battery is estimated to be low. In this case, it is preferable to perform a calculation using the average charge state ratio S so as to calculate the assembly battery charge state $C_{PACK}$ only on the high charge state side.

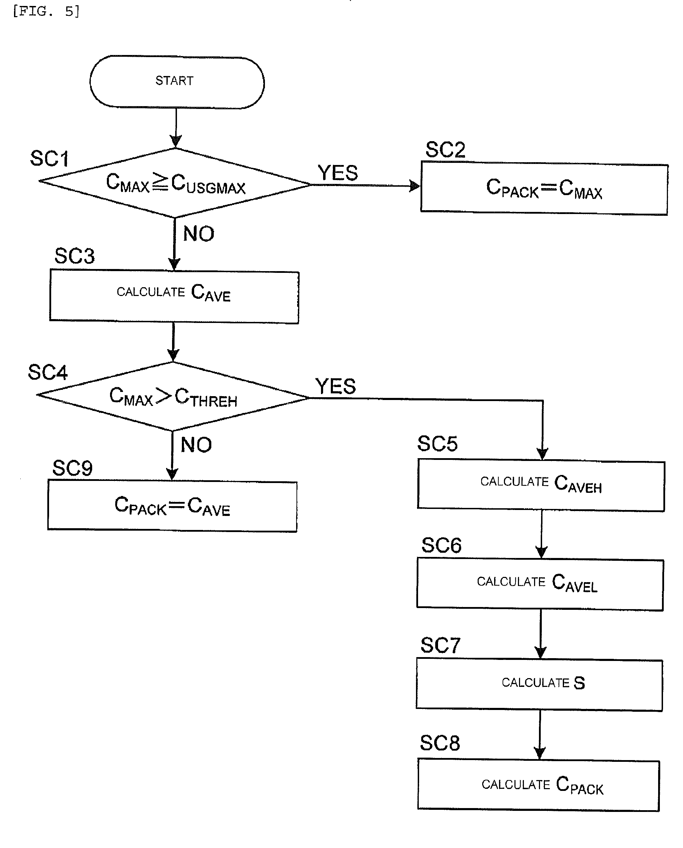

Fig. 5 illustrates a calculation flow for a assembly battery charge state performed in the present example.

The assembly battery control unit 150 or the storage unit 180 records an SOC of 90% in advance as the upper limit charge state $C_{USGMAX}$ which is an upper limit state of charge in a normal usage range of the battery 111, and an SOC of 80% as an upper boundary charge state $C_{THREH}$ used when the assembly battery charge state $C_{PACK}$ is obtained. Such numerical values of SOC are not limited to the above numerical values, and may employ optimal values based on characteristics, a usage method and a usage environment of a battery.

The upper boundary charge state $C_{THREH}$ is a boundary charge state which allows a calculation method of a state of charge to be changed by using the value as a boundary, and is set as a value for dividing the normal usage range into two ranges including a high SOC range, and another standard SOC range. In the normal usage range, a range between the upper limit charge state $C_{USGMAX}$ and the upper boundary charge state $C_{THREH}$ is set as the high SOC range, and a range between the upper boundary charge state $C_{THREH}$ and the lower limit charge state $C_{USGMIN}$ is set as the standard SOC range.

The assembly battery control unit 150 sequentially calculates the state C of charge of each battery cell 111 on the basis of various information obtained through the battery cell management unit 120. After states C of charge of all the battery cells 111 are calculated, the assembly battery control unit 150 calculates the assembly battery charge state $C_{PACK}$ from the states C of charge of the respective battery cells 111 in the following method.

First, a maximal value of the states C of charge of all the battery cells 111 is set as the maximal charge state $C_{MAX}$. In addition, in step SC1, the maximal charge state $C_{MAX}$ is compared with the upper limit charge state $C_{USGMAX}$, and if the maximal charge state $C_{MAX}$ is a value which is equal to or greater than the upper limit charge state $C_{USGMAX}$ (YES), the battery cell 111 of which a state C of charge has already deviated from the normal usage range is present. In step SC2, the assembly battery charge state $C_{PACK}$ is set to the same value as the maximal charge state $C_{MAX}$ (assembly battery charge state calculation means) and the calculation of the assembly battery charge state $C_{PACK}$ finishes.

On the other hand, in step SC1, if the maximal charge state $C_{MAX}$ is less than the upper limit charge state $C_{USGMAX}$ (NO), the flow proceeds to step SC3. In step SC3, the average charge state $C_{AVE}$ is calculated (actual average charge state calculation means).

In step SC4, the maximal charge state $C_{MAX}$ is compared with the upper boundary charge state $C_{THREH}$, and it is determined whether or not the maximal charge state $C_{MAX}$ is in the high SOC range. Here, if the maximal charge state $C_{MAX}$ exceeds the upper boundary charge state $C_{THREH}$ (YES), it is determined that the maximal charge state

$C_{MAX}$ is in the high SOC range, and a process is performed in which the average charge state upper limit value $C_{AVEH}$ is obtained by using the following Equation (12) in step SC5 (average charge state upper limit value calculation means).

$$C_{AVEH} = C_{USGMAX} - (C_{MAX} - C_{AVE}) \quad (12)$$

The average charge state upper limit value $C_{AVEH}$ of the above Equation (12) is an upper limit value of the average charge state $C_{AVE}$ when the maximal charge state $C_{MAX}$ is in the high SOC range, and is an average charge state $C_{AVE}$ in a case where the maximal charge state $C_{MAX}$ of the states C of charge is assumed to be the same value as the upper limit charge state $C_{USGMAX}$ while maintaining a gap (difference) between states C of charge in relation to the states C of charge of the respective battery cells 111 during measurement.

Next, in step SC6, the average charge state lower limit value $C_{AVE}$ is obtained by using the following Equation (13) (average charge state lower limit value calculation means).

$$C_{AVEL} = C_{THREH} - (C_{MAX} - C_{AVE}) \quad (13)$$

The average charge state lower limit value $C_{AVEL}$ of the above Equation (13) is a lower limit value of the average charge state $C_{AVE}$ when the maximal charge state $C_{MAX}$ is in the high SOC range, and is an average charge state $C_{AVE}$ in a case where the maximal charge state $C_{MAX}$ of the states C of charge is assumed to be the same value as the lower boundary charge state $C_{THREL}$ while maintaining a gap (difference) between states C of charge in relation to the states C of charge of the respective battery cells 111 during measurement.

In a case where the maximal charge state $C_{MAX}$ is located between the upper limit charge state $C_{USGMAX}$ and the upper boundary charge state $C_{THREH}$ (in a case where the maximal charge state is in the high SOC range), the average charge state $C_{AVE}$ is located only between the average charge state upper limit value $C_{AVEH}$ and the average charge state lower limit value $C_{AVEL}$.

Next, in step SC7, the average charge state ratio S is obtained by using the following Equation (14) (average charge state ratio calculation means).

$$S = (C_{AVE} - C_{AVEL}) / (C_{AVEH} - C_{AVEL}) \quad (14)$$

The average charge state ratio S is a ratio value indicating where the average charge state $C_{AVE}$ is located between the average charge state upper limit value $C_{AVEH}$ and the average charge state lower limit value $C_{AVEL}$, and is expressed by a value in a range between 0 and 1 when 1 is set in a case where the average charge state $C_{AVE}$ is the same as the average charge state upper limit value $C_{AVEH}$ and 0 is set in a case where the average charge state $C_{AVE}$ is the same as the average charge state lower limit value $C_{AVEL}$.

In addition, in step SC8, the assembly battery charge state $C_{PACK}$ is obtained by using the following Equation (15) (assembly battery charge state calculation means), and the calculation of the assembly battery charge state finishes.

$$C_{PACK} = S \times C_{MAX} + (1 - S) \times C_{AVE} \quad (15)$$

In contrast, in step SC4, if the maximal charge state $C_{MAX}$ does not exceed the upper boundary charge state $C_{THREH}$ (NO), it is determined that the maximal charge state $C_{MAX}$ and the minimal charge state $C_{MIN}$ are in the standard SOC range, and the flow proceeds to step SC9. In step SC9, a process is performed in which the assembly battery charge state $C_{PACK}$ is set to the same value as the average charge state $C_{AVE}$ (assembly battery charge state calculation means), and the calculation of the assembly battery charge state $C_{PACK}$ finishes.

Due to the above-described calculation, in a case where the maximal charge state $C_{MAX}$ is in the high SOC range, the assembly battery charge state $C_{PACK}$ takes values which are calculated on the basis of a position of the average charge state $C_{AVE}$ between the average charge state upper limit value $C_{AVEH}$ and the average charge state lower limit value $C_{AVEL}$ and continuously vary in accordance with the average charge state ratio S. The assembly battery charge state $C_{PACK}$ is calculated as the same value as the average charge state $C_{AVE}$ in a case where the maximal charge state $C_{MAX}$ and the minimal charge state $C_{MIN}$ are in the standard SOC range.

The assembly battery control unit 150 sends the assembly battery charge state $C_{PACK}$ which is the calculation result to the vehicle control unit 200. On the basis of the assembly battery charge state $C_{PACK}$, the vehicle control unit 200 extracts electric power from the assembly battery 110 so as to drive the motor generator 410 by controlling the inverter 400, allows electric power generated by the motor generator 410 to be regenerated in the assembly battery 110, or controls the charger 420 so as to charge the assembly battery 110.

The assembly battery charge state $C_{PACK}$ obtained due to the above-described procedures is calculated as the same value as the average charge state $C_{AVE}$ in a case where the maximal charge state $C_{MAX}$ is in the standard SOC range equal to or less than the upper boundary charge state $C_{THREH}$. In addition, the assembly battery charge state is calculated on the basis of the average charge state ratio S indicating a position of the average charge state $C_{AVE}$ between the average charge state upper limit value $C_{AVEH}$ and the average charge state lower limit value $C_{AVEL}$ in a case where the maximal charge state $C_{MAX}$ is in the high SOC range between the upper boundary charge state $C_{THREH}$ and the upper limit charge state $C_{USGMAX}$. Therefore, as long as the assembly battery charge state is equal to or less than the upper limit charge state $C_{USGMAX}$, the states C of charge of all the battery cells 111 forming the assembly battery 110 are equal to or less than the upper limit charge state $C_{USGMAX}$, and thus can be controlled so as not to deviate from the upper limit charge state of the normal usage range.

According to the present example, in a case where the method is used in, for example, a hybrid electric vehicle, strict control on a high charge state side which may cause over-charge which is severe circumstances in a battery can be performed.

In addition, even in a case where only a single state C of charge of the battery cells 111 forming the assembly battery 110 protrudes toward a low charge state side, since the assembly battery charge state $C_{PACK}$ is set to the same value as the average charge state $C_{AVE}$ in the standard SOC range, it is possible to prevent a case where the assembly battery charge state $C_{PACK}$ follows the state C of charge of this battery cell 111 and is thus calculated to be considerably lower than an average value (average charge state $C_{AVE}$). Therefore, it is possible to properly estimate an output characteristic of a battery and thus to sufficiently use the performance of the battery.

[Example 4]

One of features of the present embodiment is to provide a configuration in which an allowable value is provided in a true assembly battery charge state, and deviation from a normal usage range of each battery cell is reliably prevented when charge and discharge are performed on the basis of a assembly battery charge state.

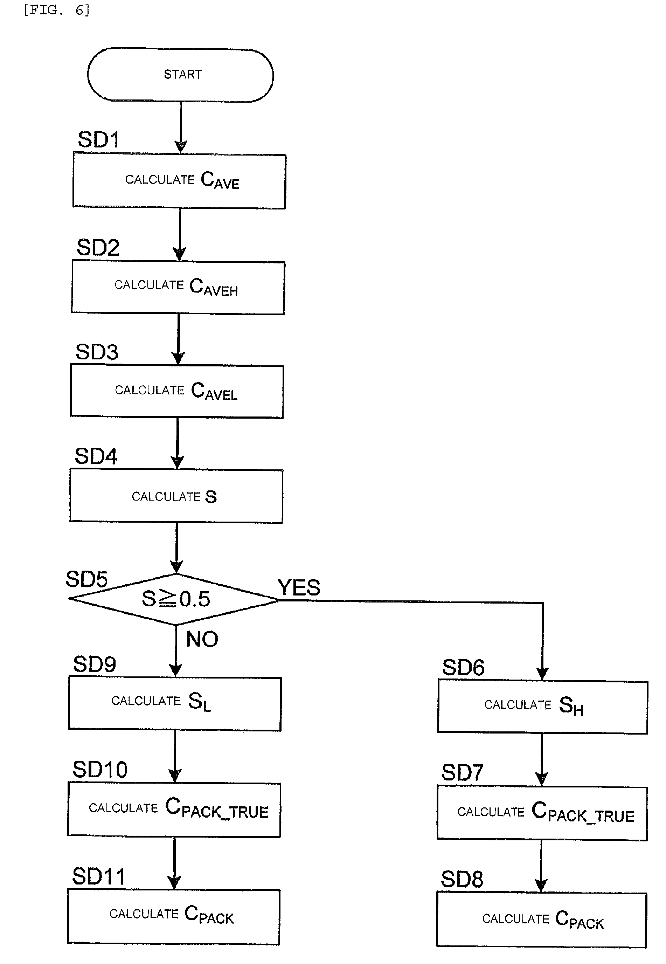

Fig. 6 illustrates a calculation flow for a assembly battery charge state performed in the present example.

The assembly battery control unit 150 or the storage unit 180 records an SOC of 90% in advance as the upper limit charge state $C_{USGMAX}$ which is an upper limit state of charge in a normal usage range of the battery 111, and similarly records an SOC of 20% as the lower limit charge state $C_{USGMIN}$ which is a lower limit state of charge in the normal usage range. In addition, 5 is recorded as an allowable value M.

The allowable value M is a value used when a true assembly battery charge state obtained through an calculation is converted into a assembly battery charge state which will be sent to the vehicle control unit 200 in practice. Such numerical values are not limited to the above numerical values, and may employ optimal values based on characteristics, a usage method and a usage environment of a battery.

The assembly battery control unit 150 sequentially calculates the state C of charge of each battery cell 111 on the basis of various information obtained through the battery cell management unit 120. After states C of charge of all the battery cells 111 are calculated, the assembly battery control unit 150 calculates the assembly battery charge state $C_{PACK}$ from the states C of charge of the respective battery cells 111 in the following method.

First, a maximal value of the states C of charge of all the battery cells 111 is set as the maximal charge state $C_{MAX}$, and a minimal value of the states C of charge of all the battery cells 111 is set as the minimal charge state $C_{MIN}$. In addition, in step SD1, the average charge state $C_{AVE}$ is obtained by dividing a sum of the states C of charge of all the battery cells 111 by the number of battery cells 111 (real average charge state calculation means).

Next, in step SD2, the average charge state upper limit value $C_{AVEH}$ is obtained by using the following Equation (16) (average charge state upper limit value calculation means).

$$C_{AVEH} = C_{USGMAX} - (C_{MAX} - C_{AVE}) \quad (16)$$

The average charge state upper limit value $C_{AVEH}$ of the above Equation (16) is an upper limit value of the average charge state $C_{AVE}$, and is an average charge state $C_{AVE}$ in a case where the maximal charge state $C_{MAX}$ of the states C of charge is assumed to be the same value as the upper limit charge state $C_{USGMAX}$ while maintaining a gap (difference) between states C of charge in relation to the states C of charge of the respective battery cells 111 during measurement.

Next, in step SD3, the average charge state lower limit value $C_{AVEL}$ is obtained by using the following Equation (17) (average charge state lower limit value calculation means).

$$C_{AVEL} = C_{USGMIN} + (C_{AVE} - C_{MIN}) \quad (17)$$

The average charge state lower limit value $C_{AVEL}$ is a lower limit value of the average charge state $C_{AVE}$, and is an average charge state $C_{AVE}$ in a case where the minimal charge state $C_{MIN}$ of the states C of charge is assumed to be the same value as the lower limit charge state $C_{USGMIN}$ while maintaining a gap (difference) between states C of charge in relation to the states C of charge of the respective battery cells 111 during measurement.

At this time, in a case where the states C of charge of all the battery cells 111 are located between the upper limit charge state $C_{USGMAX}$ and the lower limit charge state $C_{USGMIN}$, the average charge state $C_{AVE}$ is located only between the average charge state upper limit value $C_{AVEH}$ and the average charge state lower limit value $C_{AVEL}$.

Next, in step SD4, the average charge state ratio S is obtained by using the following Equation (18) (average charge state ratio calculation means).

$$S = (C_{AVE} - C_{AVEL}) / (C_{AVEH} - C_{AVEL}) \quad (18)$$

The average charge state ratio S is a ratio value indicating where the average charge state $C_{AVE}$ is located between the average charge state upper limit value $C_{AVEH}$ and the average charge state lower limit value $C_{AVEL}$, and is expressed by a value in a range between 0 and 1 when 1 is set in a case where the average charge state $C_{AVE}$ is the same as the average charge state upper limit value $C_{AVEH}$ and 0 is set in a case where the average charge state $C_{AVE}$ is the same as the average charge state lower limit value $C_{AVEL}$.

Here, in a case where the average charge state ratio S is S=0.5, an average charge state is set as the average charge state intermediate value $C_{AVEM}$ (average charge state intermediate value calculation means). In the calculation of the assembly battery charge state $C_{PACK}$ of the present example, if the average charge state ratio S is obtained, then, the average charge state ratio S is sorted and calculated with 0.5 as a boundary in order to determine whether the assembly battery charge state $C_{PACK}$ becomes close to the maximal charge state $C_{MAX}$ or the minimal charge state $C_{MIN}$.

In step SD5, if the average charge state ratio S is S≥0.5 (YES), the maximal charge state $C_{MAX}$ and the average charge state $C_{AVE}$ are used to calculate the assembly battery charge state $C_{PACK}$.

First, in step SD6, the average charge state upper ratio $S_H$ is obtained by using the following Equation (19) (average charge state upper ratio calculation means).

$$S_H = (S - 0.5) \times 2 \quad (19)$$

The average charge state upper ratio $S_H$ is a ratio value indicating where the average charge state $C_{AVE}$ is located between the average charge state intermediate value $C_{AVEM}$ and the average charge state upper limit value $C_{AVEH}$, and is expressed by a value in a range between 0 and 1 when 0 is set in a case where the average charge state $C_{AVE}$ is the same as the average charge state intermediate value $C_{AVEM}$ and 1 is set in a case where the average charge state $C_{AVE}$ is the same as the average charge state upper limit value $C_{AVEH}$.

In addition, in step SD7, a true assembly battery charge state $C_{PACK-TRUE}$ can be obtained by using the following Equation (20).

$$C_{PACK\_TRUE} = S_H \times C_{MAX} + (1 - S_H) \times C_{AVE} \quad (20)$$

In step SD8, the assembly battery charge state $C_{PACK}$ is obtained by multiplying the true assembly battery charge state $C_{PACK\_TRUE}$ by the allowable value M in the following Equation (21), and the calculation thereof finishes.

$$C_{PACK} = C_{PACK\_TRUE} + (M \times S_H) \quad (21)$$

In contrast, in step SD5, if the average charge state ratio S is S<0.5 (NO), the minimal charge state $C_{MIN}$ and the average charge state $C_{AVE}$ are used to calculate the assembly battery charge state $C_{PACK}$.

First, in step SD9, the average charge state lower ratio $S_L$ is obtained by using the following Equation (22) (average charge state lower ratio calculation means).

$$S_L = S \times 2 \quad (22)$$

The average charge state lower ratio $S_L$ is a ratio value indicating where the average charge state $C_{AVE}$ is located between the average charge state lower limit value $C_{AVEL}$ and the average charge state intermediate value $C_{AVEM}$, and is expressed by a value in a range between 0 and 1 when 0 is set in a case where the average charge state $C_{AVE}$ is the same as the average charge state lower limit value $C_{AVEL}$ and 1 is set in a case where the average charge state $C_{AVE}$ is the same as the average charge state intermediate value $C_{AVEM}$.

In addition, in step SD10, the true assembly battery charge state $C_{PACK\_TRUE}$ can be obtained by using the following Equation (23).

$$C_{PACK\_TRUE} = S_L \times C_{AVE} + (1 - S_L) \times C_{MIN} \quad (23)$$

In step SD11, the assembly battery charge state $C_{PACK}$ is obtained by multiplying the true assembly battery charge state $C_{PACK-TRUE}$ by the allowable value M in the following Equation (24), and the calculation thereof finishes (assembly battery charge state calculation means).

$$C_{PACK} = C_{PACK\_TRUE} - (M \times (1 - S_H)) \quad (24)$$

The assembly battery control unit 150 sends the assembly battery charge state $C_{PACK}$ to the vehicle control unit 200. On the basis of the assembly battery charge state $C_{PACK}$, the vehicle control unit 200 extracts electric power from the assembly battery 110 so as to drive the motor generator 410 by controlling the inverter 400, allows electric power generated by the motor generator 410 to be regenerated in the assembly battery 110, or controls the charger 420 so as to charge the assembly battery 110.

When the assembly battery charge state $C_{PACK}$ which has been obtained due to the above-described procedures continuously varies between the lower limit charge state $C_{USGMIN}$ and the upper limit charge state $C_{USGMAX}$, and the allowable value M is set to a positive value, the assembly battery charge state $C_{PACK}$ is a value which is greater than the true assembly battery charge state $C_{PACK\_TRUE}$ by the allowable value M in a case where the true assembly battery charge state $C_{PACK\_TRUE}$ is the same value as the upper limit value of the normal usage range, and the assembly battery charge state $C_{PACK}$ is a value which is smaller than the true assembly battery charge state $C_{PACK\_TRUE}$ by the allowable value M in a case where the true assembly battery charge state $C_{PACK\_TRUE}$ is the same value as the lower limit value of the normal usage range.

In this case, if charge and discharge are performed on the basis of the assembly battery charge state $C_{PACK}$, it is possible to more reliably prevent deviation from a usage range. Therefore, in a case or the like where accuracy of charge and discharge control is not high, even if the assembly battery charge state $C_{PACK}$ deviates from the usage range, the true assembly battery charge state $C_{PACK\_TRUE}$ can be controlled so that there is no battery cell 111 deviating from the usage range as long as the assembly battery charge state is in a range of the allowable value M.

When the allowable value M is set to a negative value, the assembly battery charge state $C_{PACK}$ is a value which is smaller than the true assembly battery charge state $C_{PACK\_TRUE}$ by the allowable value M in a case where the true assembly battery charge state $C_{PACK\_TRUE}$ is the same value as the upper limit value of the usage range, and the assembly battery charge state $C_{PACK}$ is a value which is greater than the true assembly battery charge state $C_{PACK-TRUE}$ by the allowable value M in a case where the true assembly battery charge state $C_{PACK\_TRUE}$ is the same value as the lower limit value of the usage range. Setting a usage range having a preliminarily sufficient margin is suitable for a case or the like where charge and discharge are performed in a usage range including an allowable value when there is no problem in practical use even in use in an overall range to which an allowable amount is added, when an output of a battery is desired to be ensured, and the like.

As mentioned above, the battery cell described in the above Examples may be a battery module in which a plurality of battery cells are combined together.

As mentioned above, although the embodiment of the present invention has been described in detail, the present invention is not limited to the embodiment, and may have various design modifications in the scope without departing from the spirit of the present invention recited in the claims. For example, the above-described embodiment has been described in detail for better understanding of the present invention, and thus is not limited to a configuration which necessarily includes all the above-described constituent elements. In addition, some configurations of a certain embodiment may be replaced with configurations of another embodiment, and configurations of another embodiment may be added to configurations of a certain embodiment. Further, addition, deletion, and replacement of another configuration may be performed with respect to a part of a configuration of each embodiment.

Reference Signs List

| | |
|---|---|
| 100 | Battery system |
| 110 | Assembly battery |
| 111 | Battery cell |
| 112 | Battery cell group |
| 120 | Battery cell management unit |
| 121 | Battery cell control portion |
| 150 | Assembly battery control unit |

**Claims**

1. A battery controller which controls a assembly battery formed by connecting a plurality of battery cells, the battery controller comprising:

   actual average charge state calculation means for calculating an actual average charge state which is an average charge state of the plurality of battery cells on the basis of each state of charge of the plurality of battery cells;
   average charge state upper limit value calculation means for calculating an average charge state upper limit value taken by the average charge state of the plurality of battery cells in a preset usage range on the basis of each state of charge and the actual average charge state of the plurality of battery cells;
   average charge state lower limit value calculation means for calculating an average charge state lower limit value taken by the average charge state of the plurality of battery cells in a preset usage range on the basis of each state of charge and the actual average charge state of the plurality of battery cells;
   average charge state ratio calculation means for calculating an average charge state ratio indicating a position of the actual average charge state between the average charge state upper limit value and the average charge state lower limit value; and
   assembly battery charge state calculation means for calculating a assembly battery charge state of the assembly battery on the basis of the actual average charge state, the average charge state upper limit value, the average charge state lower limit value, and the average charge state ratio.

2. The battery controller according to claim 1,
   wherein the average charge state upper limit value calculation means calculates an average charge state of the battery cells as the average charge state upper limit value when a maximal charge state of the states of charge of the plurality of battery cells is assumed to be a same value as a preset upper limit charge state while maintaining a gap between the respective states of charge of the plurality of battery cells, and
   wherein the average charge state lower limit value calculation means calculates an average charge state of the battery cells as the average charge state lower limit value when a minimal charge state of the states of charge of the plurality of battery cells is assumed to be a same value as a preset lower limit charge state while maintaining a gap between the respective states of charge of the plurality of battery cells.

3. The battery controller according to claim 2, further comprising:

average charge state intermediate value calculation means for calculating an average charge state intermediate value which is an average charge state which is located at a half-way position between the average charge state upper limit value and the average charge state lower limit value;

average charge state upper ratio calculation means for calculating an average charge state upper ratio indicating a position of the actual average charge state between the average charge state intermediate value and the average charge state upper limit value on the basis of the average charge state ratio; and

average charge state lower ratio calculation means for calculating an average charge state lower ratio indicating a position of the actual average charge state between the average charge state intermediate value and the average charge state lower limit value on the basis of the average charge state ratio,

wherein the assembly battery charge state calculation means calculates the assembly battery charge state on the basis of the maximal charge state, the average charge state, and the average charge state upper ratio when the average charge state ratio is equal to or higher than 0.5, and calculates the assembly battery charge state on the basis of the minimal charge state, the average charge state, and the average charge state lower ratio when the average charge state ratio is lower than 0.5.

4. The battery controller according to claim 1,
wherein the assembly battery charge state calculation means calculates the assembly battery charge state as a same value as the average charge state when a maximal charge state of the states of charge is equal to or less than a preset upper boundary charge state and a minimal charge state thereof is equal to or more than a preset lower boundary charge state while maintaining a gap between the respective states of charge of the plurality of battery cells.

5. The battery controller according to claim 4,
wherein, when the maximal charge state is more than the upper boundary charge state,
the average charge state upper limit value calculation means calculates the average charge state of the plurality of battery cells as the average charge state upper limit value when the maximal charge state is assumed to be a same value as a preset upper limit charge state while maintaining a gap between the respective states of charge of the plurality of battery cells, and
the average charge state lower limit value calculation means calculates the average charge state of the plurality of battery cells as the average charge state lower limit value when the maximal charge state is assumed to be a same value as the upper boundary charge state while maintaining a gap between the respective states of charge of the plurality of battery cells.

6. The battery controller according to claim 4,
wherein, when the minimal charge state is less than the lower boundary charge state,
the average charge state upper limit value calculation means calculates the average charge state of the plurality of battery cells as the average charge state upper limit value when the minimal charge state is assumed to be a same value as the lower boundary charge state while maintaining a gap between the respective states of charge of the plurality of battery cells, and
the average charge state lower limit value calculation means calculates the average charge state of the plurality of battery cells as the average charge state lower limit value when the minimal charge state is assumed to be a same value as a preset lower limit charge state while maintaining a gap between the respective states of charge of the plurality of battery cells.

7. The battery controller according to claim 1,
wherein the assembly battery charge state calculation means calculates the assembly battery charge state as a same value as the average charge state when a maximal charge state of the states of charge is equal to or less than a preset upper boundary charge state while maintaining a gap between the respective states of charge of the plurality of battery cells.

8. The battery controller according to claim 7,
wherein, when the maximal charge state is more than the upper boundary charge state,
the average charge state upper limit value calculation means calculates the average charge state of the plurality of battery cells as the average charge state upper limit value when the maximal charge state is assumed to be a same value as a preset upper limit charge state while maintaining a gap between the respective states of charge of the plurality of battery cells, and
the average charge state lower limit value calculation means calculates the average charge state of the plurality of battery cells as the average charge state lower limit value when the maximal charge state is assumed to be a same value as the upper boundary charge state while maintaining a gap between the respective states of charge of the plurality of battery cells.

9. The battery controller according to any one of claims 1 to 8,
   wherein the assembly battery charge state calculation means calculates the assembly battery charge state as a same value as a maximal charge state when the maximal charge state of the states of charge of the plurality of battery cells is equal to or more than the upper limit charge state.

10. The battery controller according to any one of claims 1 to 6,
    wherein the assembly battery charge state calculation means calculates the assembly battery charge state as a same value as a minimal charge state when the minimal charge state of the states of charge of the plurality of battery cells is equal to or less than the lower limit charge state.

11. The battery controller according to claim 3,
    wherein the assembly battery charge state calculation means multiplies the assembly battery charge state by a preset allowable value.

[FIG. 1]

CHARGER

420

330

320

112b
111
112a
111

CURRENT DETECTION UNIT

110

BATTERY CELL CONTROL PORTION

BATTERY CELL CONTROL PORTION

120

130

100

121b
121a

INSULATING
INSULATING

170
170

160
160
160

200

VEHICLE CONTROL UNIT

ASSEMBLY BATTERY CONTROL UNIT

150

180

140

VOLTAGE DETECTION UNIT

310

300

INVERTER

400

M/G

410

[FIG. 2]

VOLTAGE DETECTION CIRCUIT SECTION

TEMPERATURE DETECTION SECTION

CONTROL CIRCUIT SECTION

SIGNAL INPUT AND OUTPUT CIRCUIT SECTION

COMMUNICATION WITH ASSEMBLY BATTERY CONTROL UNIT

112

111

123  121  124

122

125

EP 2 765 435 A1

21

[FIG. 3]

```
                        ┌─────────────┐
                        │    START    │
                        └─────────────┘
                               │
                               ▼
        SA1        ◇───────────────────────◇    YES    SA2
                   < C_MAX ≧ C_USGMAX >─────────────►  ┌──────────────────┐
                   ◇───────────────────────◇          │  C_PACK = C_MAX  │
                               │ NO                    └──────────────────┘
                               ▼
        SA3        ◇───────────────────────◇    YES    SA4
                   < C_MIN ≦ C_USGMIN >─────────────►  ┌──────────────────┐
                   ◇───────────────────────◇          │  C_PACK = C_MIN  │
                               │ NO                    └──────────────────┘
                               ▼
        SA5        ┌───────────────────────┐
                   │   CALCULATE C_AVE     │
                   └───────────────────────┘
                               │
                               ▼
        SA6        ┌───────────────────────┐
                   │   CALCULATE C_AVEH    │
                   └───────────────────────┘
                               │
                               ▼
        SA7        ┌───────────────────────┐
                   │   CALCULATE C_AVEL    │
                   └───────────────────────┘
                               │
                               ▼
        SA8        ┌───────────────────────┐
                   │     CALCULATE S       │
                   └───────────────────────┘
                               │
                               ▼
        SA9            ◇───────────◇    YES
                       <  S ≧ 0.5  >────────────────────┐
                       ◇───────────◇                    │
                               │ NO                      │
        SA12                   ▼              SA10       ▼
                   ┌───────────────────────┐  ┌───────────────────────┐
                   │   CALCULATE S_L       │  │   CALCULATE S_H       │
                   └───────────────────────┘  └───────────────────────┘
                               │                          │
        SA13                   ▼              SA11        ▼
                   ┌───────────────────────┐  ┌───────────────────────┐
                   │   CALCULATE C_PACK    │  │   CALCULATE C_PACK    │
                   └───────────────────────┘  └───────────────────────┘
```

[FIG. 4]

[FIG. 5]

```
                    ┌──────────────┐
                    │    START     │
                    └──────┬───────┘
                           │
                           ▼
SC1                  ◇ $C_{MAX} \geqq C_{USGMAX}$ ◇ ──YES──▶  SC2 ┌────────────────────┐
                           │                                      │  $C_{PACK} = C_{MAX}$  │
                          NO                                      └────────────────────┘
                           │
                           ▼
SC3  ┌────────────────────────┐
     │   CALCULATE $C_{AVE}$    │
     └────────────┬───────────┘
                  │
                  ▼
SC4          ◇ $C_{MAX} > C_{THREH}$ ◇ ──YES──────────────┐
                  │                                        │
                 NO                                        ▼
                  │                           SC5 ┌────────────────────────┐
SC9 ┌──────────────────────┐                      │  CALCULATE $C_{AVEH}$    │
    │  $C_{PACK} = C_{AVE}$   │                      └────────────┬───────────┘
    └──────────────────────┘                                   │
                                                               ▼
                                            SC6 ┌────────────────────────┐
                                                │  CALCULATE $C_{AVEL}$    │
                                                └────────────┬───────────┘
                                                             │
                                                             ▼
                                            SC7 ┌────────────────────────┐
                                                │     CALCULATE $S$       │
                                                └────────────┬───────────┘
                                                             │
                                                             ▼
                                            SC8 ┌────────────────────────┐
                                                │  CALCULATE $C_{PACK}$   │
                                                └────────────────────────┘
```

[FIG. 6]

[FIG. 7]

(a)

(b)

BATTERY CELL CHARGE STATE

AVERAGE CHARGE STATE

## INTERNATIONAL SEARCH REPORT

| | International application No. |
|---|---|
| | PCT/JP2011/073114 |

A. CLASSIFICATION OF SUBJECT MATTER
*G01R31/36*(2006.01)i

According to International Patent Classification (IPC) or to both national classification and IPC

B. FIELDS SEARCHED

Minimum documentation searched (classification system followed by classification symbols)
G01R31/36

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2010-141970 A  (Mitsubishi Heavy Industries, Ltd.), 24 June 2010 (24.06.2010), entire text; all drawings & WO 2010/067735 A1 | 1-11 |
| A | JP 2004-31012 A  (Nissan Motor Co., Ltd.), 29 January 2004 (29.01.2004), entire text; all drawings (Family: none) | 1-11 |
| A | JP 2001-153935 A  (Sanyo Electric Co., Ltd.), 08 June 2001 (08.06.2001), entire text; all drawings (Family: none) | 1-11 |

☐ Further documents are listed in the continuation of Box C.     ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 21 December, 2011 (21.12.11) | 10 January, 2012 (10.01.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11185823 A